# EUROPEAN PATENT SPECIFICATION

(11) **EP 1 990 089 B1**
(45) Date of publication and mention of the grant of the patent: **30.03.2016**
(21) Application number: 07123621.0
(22) Date of filing: 19.12.2007
(51) Int. Cl.: B01J 13/06, B01J 21/18, B01J 23/34, B01J 23/745, B01J 23/75, B01J 23/755

(54) **A method and equipment of producing graphite and metallic catalyst composite for diamond synthesis**
Verfahren und Ausrüstung zur Herstellung von Grafit- und Metallkatalysatorkompositen für die Synthese von Diamanten
Procédé et équipement pour la production de graphite et composite catalyseur métallique pour la synthèse de diamant

(30) Priority: 30.12.2006 CN 200610156071
(43) Date of publication of application: 12.11.2008
(73) Proprietor: Jiangsu Tianyi Micro Metal Powder Co. Ltd., Huai An City, 211734 Jiangsu (CN)
(72) Inventor: Gao, Weixin, 211734, Jiangsu (CN); Wang, Bin, 211734, Jiangsu (CN); Ke, Zunbin, 211734, Jiangsu (CN)
(74) Representative: Staudt, Hans-Peter

(56) References cited:
- I. SANDU: "EFFEC OF NICKEL COATING ON ELECTROCHEMICAL PERFORMANCE OF GRAPHITE ANODES FOR LITHIUM ION BATTERIES" IONICS, vol. 9, 10 December 2003 (2003-12-10), pages 329-335, XP002555820

## Description

### Field of the invention

This invention releases the preparation method and equipment of graphite and catalyst composite for a kind of diamond synthesis, concretely to that a monolayer or composite coating of nickel, iron, manganese, cobalt or other accelerant element can be formed on the graphite grain surface by decomposing carbonyl metal compound such as nickel tetracarbonyl, iron pentacarbonyl, dimanganese decacarbonyl, dicobalt octacarbonyl. What especially involves is using caloric provided by heated graphite for thermal decomposition of carbonyl metals as nickel tetracarbonyl, iron pentacarbonyl, dimanganese decacarbonyl, dicobalt octacarbonyl and forming a nickel, iron, manganese cladding on the surface of graphite. Compound materials of graphite, nickel, iron, manganese and cobalt are used for extruding compound stick for synthetic diamond.

### Background of the invention

Synthesizing diamond under a static high-pressure must make use of catalysis of transition metal or alloy to actualize transform from graphite to diamond under a high temperature and high pressure. Traditional synthesis technics is assembling sheet Ni₇₀Mn₂₅Co₅ alloy accelerant and graphite by turns into a synthesizing cavity to synthesize. Diamond grows along the adjacent edge of graphite sheets and catalyst sheets. In recent years, the arisen technics of powder catalyst accelerates the promotion of conversion rate in diamond synthesizing.

In <Study on Catalyzing Efficiency of Sheet or Powdery Catalyst for Graphite Synthesizing Diamond> of TANG Jingyou, it is considered that using powder catalyst technics, graphite and catalyst powder can fully mix. There is a bigger tangent area between the twos. It is needn't a long-distance pervasion when graphite synthesizing diamond. The transfer rate of graphite to diamond the rate will increase greatly.

In same synthesis conditions, the catalyst powder produce yield and conversion volume fraction is even five times than sheet catalyst.

In <New Technology and development of Chinese superhard materials > of Fang Xiaohu, it is said that "Both metal powder and graphite powder should better with particle size and be fine than 200 mesh, and mixing round in a appropriate technics", "a lower rate of metal and graphite powder is suitable", "In the synthesis process with powder catalyst, there is must a metal film. Those who have no metal film or film is not complete, the diamond must grow not will. Metal film is in the role of transferring carbon to the diamond nucleus, accelerating it growing up. In the whole course, it will stop when appearing a ill status, or the crystal will grow incompletely. The characteristic of powdery Catalyst is that it is easy to form a metal film. Moreover, the metal film and diamond nucleus is a kind of a monomer. It is an isolated, fine globular and omnidirectional globule. Its existence is so important that in case it has been formed and hold to the whole growth phase, the diamond is quite intact single crystal."

Powder catalyst of the above is based on mixing metal powder with graphite powder. As the widely difference in density of metals and graphite powder, it is easy to segregate in mixing process. In addition, it is non-continuous when metal powders distributing in graphite. On the whole synthesizing cavity or appearance of single graphite particle, the environment is difficult to form a seriate metal film. It affects the growth of diamond crystals.

"Effect of Nickel coating on Electrochemical performance of Graphite Anodes for Lithium Ion Batteries", I. Sandu et al., Ionics 9, 2003, pages 329-335, discloses that a precursor (nickel carbonyl) and a carrier gas (95 vol% Ar and 5 vol% H₂) are heated in a furnace at 150 °C at a pressure of 10Pa. Inside the furnace, a mixing machine is provided with a rotating motor in order to insure nickel deposition on the graphite particles.

The purpose of this invention is to provide a method and interrelated equipment of preparing composite material of graphite and catalyst for synthetic diamond. It plates metal film by thermal decomposing carbonyl metal compound on graphite particles and thereby prepares compound material of graphite and metal catalyst. It is used to replace current mixture of metal powder and graphite powder for synthetic diamond.The compositive stick made by compound material of graphite and metal catalyst can form a seriate metal film. When synthesizing diamonds, both the whole synthesizing cavity and the appearance of single graphite particle is very easy to form a seriate metal film, transport carbon to diamond crystal nucleus continuously and make the growth of diamond crystal intact.

The object underlying the present invention is solved by a method as claimed in claim 1 and an equipment as claimed in claim 8. Preferred embodiments are defined in dependent claims 1 to 7 and 9.

The purpose of this invention is achieved by the following technical schemes:
According to the need of different specifications diamond, graphite with different size or different size distribution is pre-heat. Nickel, iron, cobalt, manganese carbonyl complexes decompose on the surface of graphite using caloric provided by heated graphite. The surface of graphite can be equably plated monolayer or compound layer of metal catalyst elementary as nickel, iron, cobalt, manganese. The method includes the following steps:
   a. The clean, pollution-free and high-purity graphite particles are placed in the heating chamber, and pre-heat in a vacuum or nitrogen, argon atmosphere.
   b. Well heated graphite particles are transported to a plating room with vibrator or blender. Turn on the entering switch of carbonyl metals steam. Input carbonyl metals steam to the plating room, turn on vibrator or blender, and equably plate metal catalyst layer on the graphite surface by decomposing metal carbonyl compound using caloric provided by heated graphite.
   c. Plated graphite particles are delivered to cooling and passivating room. They are taken out after cooling and passivating or delivered to next heating-plating cycle until the thickness of film is up to request. At last, they are cooled, passivated, taken out, and passivated, packed.

When pre-heating the graphite, the lowest heating temperature should be higher than the boiling point of metal carbonyl compound for plating. The highest temperature should be determined by the need of plating thickness.

The thicker of plating layer, the higher temperature is needed. On contrary, the thinner of plating layer, the lower temperature is needed. The concrete temperature is confirmed by calculating the quantity of heat needed by decomposing a unit mol volume of metal carbonyl compound.

In this invention, when pre-heating graphite, the heating temperature in a choice must be above the boiling point temperature of metal carbonyl compound as plating material t_{f} to t_{f}+800°C, it is preferred in a temperature range from t_{f}+50°C to t_{f}+600°C.

The metal carbonyl compound as plating material is at least one of Fe(CO)₅, Co₂(CO)₈, Ni(CO)₄, Mn₂(CO)₁₀.

The plating layer of metal catalyst contains at least one of Fe, Co, Ni, Mn.

In the next pre-heating and plating cycle, the metal carbonyl compound can be the same of superior one to increase the thickness of film. It also can change the kind of metal carbonyl compound and plating another element. Elements can be plated alternately or mixed.

An equipment of the preparation method, its features are: made up of one or more heating chambers, one or more plating rooms, one or more vaporizing rooms of metal carbonyl compound and one cooling and passivating room. Heating chamber is connected with plating room which has a vibrator or blender inside. Plating room is connected with vaporizing room and cooling and passivating room.

Each room is set up with enter or outer meatus for protection gas and switch for connection one another. Connection of heating chambers, plating rooms, vaporizing rooms, cooling and passivating rooms can he series-wound or shunt-wound. Thereby, a close, continuous, monolayer or multilayer and single element or multi-elements plating can be actualized.

To graphite and catalysts compound material prepared by the method of this invention, surface of each graphite particle is coated with a catalyst metal layer. When using for compositive stick, the metal can form a seriate metal film. When synthesizing diamonds, both the whole synthesizing cavity and the appearance of single graphite particle is very easy to form a seriate metal film, transport carbon to diamond crystal nucleus continuously and make the growth of diamond crystal intact. Method in this invention is a new method knowing from agone methods of plating metal film on the surface of particles. Its technics is simple. It has conquered shortcomings such as bad sorption between plating material and plated material surface, and asymmetric plating in traditional MOCVD method.

### Brief description of the drawings

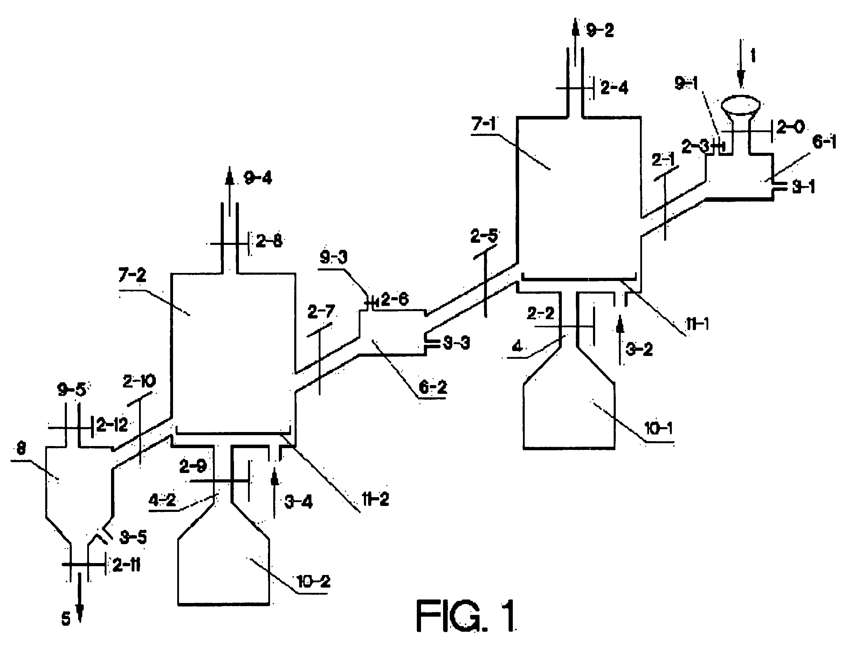

Fig 1. is the technics flow frame sketch map of this invention.

In the Figure: 1. Entering Filler of Graphite, 2. Switch (0∼n), 3. Entering Stomata of Protection Gas (1∼n), 4. Entering Stomata of Metal Carbonyl Compound Steam (1∼n), 5. Products Discharging Stomata, 6. Heating Chamber (1-n), 7. Plating Room (1∼n), 8. Cooling and Passivating Room, 9. Protection Gas Vent or Vacuumizing Stomata I (1∼n), 10. Vaporizing Room (1∼n), 11. Vibrator or Blender (1∼n).

### Specific Implement

The method described in this invention concretely includes following steps:
a. The clean, pollution-free and high-purity graphite particles are placed in the heating chamber 6. In order to be free from oxidation and pollution, it must be heated in a vacuum or nitrogen, argon atmosphere. When pre-heating the graphite, the lowest heating temperature should be higher than the boiling point of metal carbonyl compound for plating. The highest temperature should be determined by the need of plating thickness. The thicker of plating layer, the higher temperature is needed. On contrary, the thinner of plating layer, the lower temperature is needed. The concrete temperature is confirmed by calculating the quantity of heat needed by decomposing a unit mol volume of metal carbonyl compound.
b. After being heated to the needed temperature, graphite particles are transported to a plating room 7 with vibrator or blender 11. Turn on the entering switch of carbonyl metals steam 4. Input carbonyl metals steam to the plating room 7, turn on vibrator or blender 11 to plate.
c. Plated graphite particles are delivered to cooling and passivating room 8. They are taken out after cooling and passivating or delivered to next heating-plating cycle until the thickness of film is up to request. At last, they are cooled, passivated, taken out, and passivated, packed.

In this invention, when pre-heating graphite, the heating temperature in a choice must be above the boiling point temperature of metal carbonyl compound as plating material t_{f} to t_{f}+800°C, it is preferred in a temperature range from t_{f}+50°C to t_{f}+600°C.

The metal carbonyl compound as plating material is at least one of Fe(CO)₅, Co₂(CO)₈, Ni(CO)₄, Mn₂(CO)₁₀.

The plating layer of metal catalyst contains at least one of Fe, Co, Ni, Mn.

In the next pre-heating and plating cycle, the metal carbonyl compound can be the same of superior one to increase the thickness of film. It also can change the kind of metal carbonyl compound and plating another element. Elements can be plated alternately or mixed.

An equipment of the preparation method consists one or more heating chambers 6, one or more plating rooms 7, one or more vaporizing rooms of metal carbonyl compound 10 and one cooling and passivating room 8. Heating chamber 6 is connected with plating room 7 which has a vibrator or blender 11 inside. Plating room 7 is connected with vaporizing room 10 and cooling and passivating room 8.

Each room is set up with enter or outer meatus 3, 9 for protection gas and switch 2 for connection one another. Connection of heating chambers 6, plating rooms 7, vaporizing rooms 10, cooling and passivating rooms can be series-wound or shunt-wound. Thereby, a close, continuous, monolayer or multilayer and single element or multi-elements plating can be actualized.

It is illustrated with plating iron on graphite combining figure 1:
1. Graphite particles are added to heating chamber 6-1 via the entering filler of graphite. Then turn off the switch 2-0.
2. The entire system is vacuumized or replacement the atmosphere by N₂, Ar₂.
3. Switch on the heat fountain of heating chamber 6-1, heat up the graphite to 800 ° C.
4. Switch on the heat fountain of vaporizing room 10-1, heat it up to above 104° C.
5. When the scheduled temperature of steps 3, 4 is reached, turn on the switching 2-1 between heating chamber 6-1 and plating room 7-1, deliver the heated graphite of heating chamber 6-1 into plating room 7-1. Then, turn off the switching 2-1 between heating chamber 6-1 and plating room 7-1, put Fe(CO)₅ in vaporizing room 10-1. Turn on the switching 2-2 between vaporizing room 10-1 and plating room 7-1, transport Fe(CO)₅ stream into plating room 7-1, and run vibrator or blender 11-1 to plate.
6. Turn off the switching 2-2 between vaporizing room 10-1 and plating room 7-1, turn on the switching 2-10 between cooling and passivating room 8 and plating room 7-1, transport the plated graphite to cooling and passivating room 8, and take it out after cooling and passivating. This step is limited after the last time of one-off or repetitious plating.
7. Turn on the switching 2-5, add the plated graphite to heating chamber 6-2 to heat up again, and come into next plating, cycle so, till the plating thickness reaches prospective one. Then, transport it to cooling and passivating room 8 to passivate again.
8. Well plated and cooled and passivated composite material of graphite and accelerant is discharged from material discharging stomata 5. Sublimate and pack at last.

## Claims

1. A method of producing graphite and metallic catalyst composite for diamond synthesis, with the characteristics including the following steps:
a. The clean high-pure graphite particle will at first be placed in a heating chamber (6) for preheating the graphite particle with the protection of vacuum or nitrogen and argon gas. The pre-heating temperature of said heating chamber (6) is set to be higher than the boiling point (t_{f}) of a metal carbonyl compound to be selected from a group of compounds consisting of Fe(CO)₅, Co₂(CO)₈, Ni(CO)₄ and Mn₂(CO)₁₀ for plating. The upper limit of temperature is set depending on the thickness of plating layer with the temperature being set to be higher when the thickness of the plating layer of the product increases, wherein the specific temperature is determined by calculating the quantity of energy which is used to decompose said metal carbonyl compound and the pre-heating temperature is adjusted between t_{f} and t_{f}+800°C;
b. The heated graphite particles then shall be fed into a plating room (7) with a vibrator or agitator (11) and then an inlet switch of the steam of carbonyl metal complex as the coating will be opened to feed the steam of metal carbonyl from a vaporizing room (10) into the plating room (7); after that, the vibrator or agitator (11) will be operated and the metal carbonyl decomposes on the graphite surface forming metal layer to the graphite surface evenly by means of the heat of the heated graphite;
c. The coated graphite particles then will be fed into the cooling and passivating room (8) for cooling and passivating of the discharging materials or enter the next round circle of heating and coating until it reaches up to the needed coating thickness; finally, the composite materials will be cooled, passivated and packaged.

2. The method according to claim 1, **characterized in that** the metal carbonyl of Fe, Co, Ni and Mn decomposes by means of the heat of the heated graphite particles.

3. The method according to claim 1, **characterized in that** the graphite particles are preheated with the heating temperature from t_{f}+50°C to t_{f}+600°C.

4. The method according to claim 1, **characterized in that** the carbonyl metal coating stated includes one of the materials selected from Fe, Co, Ni and Mn at least.

5. The method according to claim 1, **characterized in that** the next round circle of heating and coating stated in step c can coat the same metallic element to the last round and change the variety of the carbonyl metal complex and coat other metallic elements. The coating of several metallic elements can be carried out in manner of alternation or mixing.

6. An equipment for producing graphite and catalyst composite for the diamond synthesis according to any of claims 1 to 5, comprising one heating chamber (6) comprising means to heat in a vacuum or nitrogen, argon atmosphere to a temperature which is adjusted to be set between t_{f} and t_{f}+800°C, one plating room (7) adapted to be heated to a temperature which is above t_{f} in order to avoid that metal carbonyl compound condensates, one vaporizing chamber of carbonyl metal complex (10), said metal carbonyl compound being selected from a group of compounds consisting of Fe(CO)₅, Co₂(CO)₈, Ni(CO)₄ and Mn₂(CO)₁₀, and one cooling and passivating room (8), wherein said heating chamber (6) and said plating room (7) are connected and the vaporizing room (10) is connected with said plating room (7) and said plating room (7) is connected with said cooling and passivating room (8), wherein each room is provided with an inlet and outlet (3, 9) of the protective gas and interconnecting switches (2) and wherein the plating room is provided with a vibrator or agitator (11).

7. The equipment according to claim 6, **characterized in that** the heating chamber (6), vaporizing room (10), plating room (7) and cooling and passivating room (8) can be assembled in form of multi cascade connection to realize a closed and continuous single-element or multi-element plating.

## Patentansprüche

1. Verfahren zur Herstellung eines Grafit- und Metallkatalysatorkomposits für die Synthese von Diamanten mit den Kennzeichen umfassend die folgenden Schritte:
a. das saubere, hochreine Grafitteilchen wird zunächst in eine Heizkammer (6) zum Vorheizen des Grafitteilchens unter Vakuum- oder Stickstoff- und Argongas-Schutz gegeben; die Vorheiztemperatur der Heizkammer (6) wird höher eingestellt als der Siedepunkt (t_{f}) einer Metallcarbonylverbindung, die aus einer Gruppe von Verbindungen zum Beschichten auszuwählen ist, die aus Fe(CO)₅, Co₂(CO)₈, Ni(CO)₄ und Mn₂(CO)₁₀ besteht; die Obergrenze der Temperatur wird je nach Dicke der Beschichtungsschicht eingestellt, wobei die Temperatur so eingestellt wird, dass sie höher ist, wenn die Dicke der Beschichtungsschicht des Produktes zunimmt, wobei die spezifische Temperatur durch Berechnen der Energiemenge bestimmt wird, die verwendet wird, um die Metallcarbonylverbindung zu zersetzen, und die Vorheiztemperatur zwischen t_{f} und t_{f}+800 °C eingestellt wird;
b. dann werden die erwärmten Grafitteilchen in einen Beschichtungsraum (7) mit einem Schwingungserzeuger oder Rührwerk (11) gegeben, und dann wird ein Einlassschalter für den Dampf von Carbonylmetallkomplex als Beschichtung geöffnet, um den Dampf von Metallcarbonyl von einem Verdampfungsraum (10) in den Beschichtungsraum (7) zuzuführen; danach wird der Schwingungserzeuger oder das Rührwerk (11) betrieben, und das Metallcarbonyl zersetzt sich auf der Grafitoberfläche und bildet dabei durch die Hitze des erhitzten Grafits gleichmäßig eine Metallschicht auf der Grafitoberfläche;
c. die beschichteten Grafitteilchen werden dann zum Kühlen und Passivieren der abgesetzten Materialien in den Kühl- und Passivierraum (8) gegeben oder treten in den nächsten Kreislauf des Erhitzens und Beschichtens ein, bis die erforderliche Beschichtungsdicke erreicht ist; schließlich werden die Verbundwerkstoffe gekühlt, passiviert und verpackt.

2. Verfahren nach Anspruch 1, **dadurch gekennzeichnet, dass** sich das Metallcarbonyl von Fe, Co, Ni und Mn durch die Hitze der erhitzten Grafitteilchen zersetzt.

3. Verfahren nach Anspruch 1, **dadurch gekennzeichnet, dass** die Grafitteilchen mit der Heiztemperatur von t_{f}+50 °C bis t_{f}+600 °C vorgewärmt werden.

4. Verfahren nach Anspruch 1, **dadurch gekennzeichnet, dass** die angegebene Carbonylmetallbeschichtung eines der Materialien umfasst, die wenigstens aus Fe, Co, Ni und Mn ausgewählt sind.

5. Verfahren nach Anspruch 1, **dadurch gekennzeichnet, dass** der nächste Kreislauf des Erhitzens und Beschichtens, der in Schritt c genannt ist, dasselbe metallische Element bis zur letzten Runde beschichten kann und die Vielfalt des Carbonylmetallkomplexes ändern und andere metallische Elemente beschichten kann; das Beschichten von mehreren metallischen Elementen kann auf alternierende oder gemischte Weise durchgeführt werden.

6. Vorrichtung zur Herstellung eines Grafit- und Katalysatorkomposits für die Synthese von Diamanten nach einem der Ansprüche 1 bis 5, umfassend eine Heizkammer (6), umfassend Mittel zum Erhitzen in einem Vakuum oder einer Stickstoff-, Argonatmosphäre auf eine Temperatur, die zwischen t_{f} und t_{f}+800 °C eingestellt wird, einen Beschichtungsraum (7), der dazu geeignet ist, auf eine Temperatur erwärmt zu werden, die über t_{f} liegt, um zu verhindern, dass die Metallcarbonylverbindung kondensiert, eine Verdampfungskammer von Carbonylmetallkomplex (10), wobei die Metallcarbonylverbindung aus einer Gruppe von Verbindungen ausgewählt ist, die aus Fe(CO)₅, Co₂(CO)₈, Ni(CO)₄ und Mn₂(CO)₁₀ besteht, und einen Kühl- und Passivierraum (8), wobei die Heizkammer (6) und der Beschichtungsraum (7) verbunden sind und der Verdampfungsraum (10) mit dem Beschichtungsraum (7) verbunden ist und der Beschichtungsraum (7) mit dem Kühl- und Passivierraum (8) verbunden ist, wobei jeder Raum mit einem Einlass und einem Auslass (3, 9) für das Schutzgas und mit Verbindungsschaltern (2) versehen ist,
und wobei der Beschichtungsraum mit einem Schwingungserzeuger oder einem Rührwerk (11) versehen ist.

7. Vorrichtung nach Anspruch 6, **dadurch gekennzeichnet, dass** die Heizkammer (6), der Verdampfungsraum (10), der Beschichtungsraum (7) und der Kühl- und Passivierraum (8) in Form einer Verbindung mit mehreren Kaskaden aufgebaut werden kann, um eine geschlossene und kontinuierliche Einzel-Element- oder Mehrfach-Element-Beschichtung zu verwirklichen.

## Revendications

1. Procédé de production de graphite et de composite catalyseur métallique pour la synthèse de diamant, dont les caractéristiques englobent les étapes suivantes:
a. la particule de graphite propre et ultra pure sera tout d'abord placée dans une chambre de chauffage (6) pour préchauffer la particule de graphite pour une protection sous vide ou sous azote ou argon gazeux. La température de préchauffage de ladite chambre de chauffage (6) est réglée pour être supérieure au point d'ébullition (t_{f}) d'un composé carbonyle métallique à choisir dans un groupe de composés pour la galvanoplastie constitué de Fe(CO)₅, de Co₂(CO)₈, de Ni(CO)₄ et de Mn₂(CO)₁₀. La limite supérieure de la température est réglée en fonction de l'épaisseur de la couche de placage avec un réglage à une température plus élevée lorsque l'épaisseur de la couche de placage du produit s'accroit, dans lequel la température spécifique est déterminée en calculant la quantité d'énergie qui est utilisée pour décomposer ledit composé de carbonyle métallique et la température de préchauffage est ajustée entre t_{f} et t_{f}+ 800 °C;
b. les particules de graphite chauffées seront ensuite introduites dans une chambre de placage (7) avec un vibreur ou un agitateur (11) et ensuite une commande d'entrée de la vapeur du complexe carbonylé métallique servant de revêtement sera ouverte pour envoyer la vapeur du carbonyle métallique provenant d'une chambre de vaporisation (10) vers la chambre de placage (7); après cela, le vibreur ou l'agitateur (11) sera utilisé pour décomposer le carbonyle métallique à la surface du graphite afin de former une couche métallique à la surface du graphite de manière uniforme au moyen de la chaleur du graphite chauffé;
c. les particules de graphite enrobées seront ensuite introduites dans une chambre de refroidissement et de passivation (8) pour le refroidissement et la passivation des matériaux déchargés ou commencerons le cycle suivant de chauffage et d'enrobage jusqu'à atteindre l'épaisseur nécessaire du revêtement; finalement, les matériaux composites seront refroidis, passivés et emballés.

2. Procédé selon la revendication 1, **caractérisé en ce que** le carbonyle métallique de Fe, de Co, de Ni et de Mn se décompose sous l'action de la chaleur des particules de graphite chauffées.

3. Procédé selon la revendication 1, **caractérisé en ce que** les particules de graphite sont préchauffées à une température de chauffe de t_{f}+ 50 °C à t_{f}+ 600 °C.

4. Procédé selon la revendication 1, **caractérisé en ce que** le revêtement métallique carbonylé indiqué inclut l'un des matériaux choisi parmi au moins le Fe, le Co, le Ni et le Mn.

5. Procédé selon la revendication 1, **caractérisé en ce que** le cycle suivant de chauffage et d'enrobage mentionné dans l'étape c permet de recouvrir le même élément métallique jusqu'au dernier cycle et de changer la nature du complexe métallique carbonylé et recouvrir d'autres éléments métalliques. L'enrobage de plusieurs éléments métalliques peut être effectué de manière alternative ou par mélange.

6. Equipement de production de graphite et de composite catalyseur pour la synthèse de diamant selon l'une quelconque des revendications 1 à 5, comprenant une chambre de chauffage (6) comprenant des moyens de chauffage sous vide ou sous atmosphère d'azote, d'argon à une température qui est ajustée pour s'établir entre t_{f} et t_{f}+ 800 °C, une chambre de placage (7) adaptée pour être chauffée à une température qui est au-dessus de t_{f} de façon à éviter la condensation du composé carbonylé métallique, une chambre de vaporisation du complexe métallique carbonylé (10), ledit complexe métallique carbonylé étant choisi dans un groupe de composés constitué de Fe(CO)₅, de Co₂(CO)₈, de Ni(CO)₄ et de Mn₂(CO)₁₀, et une chambre de refroidissement et de passivation (8), dans lequel ladite chambre de chauffage (6) et ladite chambre de placage (7) sont reliées et la chambre de vaporisation (10) est reliée à ladite chambre de placage (7) et ladite chambre de placage (7) est reliée à ladite chambre de refroidissement et de passivation (8), dans lequel chacune des chambres est pourvue d'une entrée et d'une sortie (3, 9) de gaz pour la conservation et de commandes d'interconnexion (2) et dans lequel la chambre de placage est pourvue d'un vibreur ou d'un agitateur.

7. Equipement selon la revendication 6, **caractérisé en ce que** la chambre de chauffage (6), la chambre de vaporisation (10), la chambre de placage (7) et la chambre de refroidissement et de passivation (8) peuvent être assemblées sous la forme d'un enchainement en cascades multiples pour réaliser un placage par élément unique fermé et continu ou par éléments multiples.
